# EUROPEAN PATENT APPLICATION

(11) **EP 3 624 178 A1**
(43) Date of publication of application: **18.03.2020**
(21) Application number: 18193824.2
(22) Date of filing: 11.09.2018
(51) Int. Cl.: H01L 21/8234, H01L 27/088

(54) **GATE, CONTACT AND FIN CUT METHOD**

(71) Applicant: IMEC vzw, 3001 Leuven (BE)
(72) Inventor: DEMUYNCK, Steven, 3001 Leuven (BE); ENEMAN, Geert, 3001 Leuven (BE); MACHKAOUTSAN, Vladimir, 3001 Leuven (BE)
(74) Representative: DenK iP

(57) **Abstract**

A method (100) of forming gate contacts and/or contact lines on a plurality of fins. The method comprises providing (110) a wafer comprising a semiconductor structure which comprises a plurality of fins. The method moreover comprises patterning (120) at least one continuous trench over the fins, and filling (130) at least one of the trenches with metal to obtain at least one continuous gate in contact with the fins and/or filling at least one of the trenches with metal to obtain at least one continuous contact line in contact with the fins. The method moreover comprises cutting (140) the metal of the at least one gate and/or cutting the metal of the at least one contact line on locations in between some of the fins.

## Description

### Field of the invention

The invention relates to the field of forming gate contacts and contact lines on a plurality of fins. More specifically it relates to methods of making gate cuts and contact cuts.

### Background of the invention

In state-of-the-art integrated circuits a plurality of transistors are integrated together on a chip. Gate contacts and contact lines are interconnecting these transistors. FinFET technology may for example be used for realizing these transistors. Typically nMOS or pMOS devices are realized.

In such technology the contact cut is typically done early in the flow. The trenches are already etched in the source and/or drain on the pMOS and nMOS side separately.

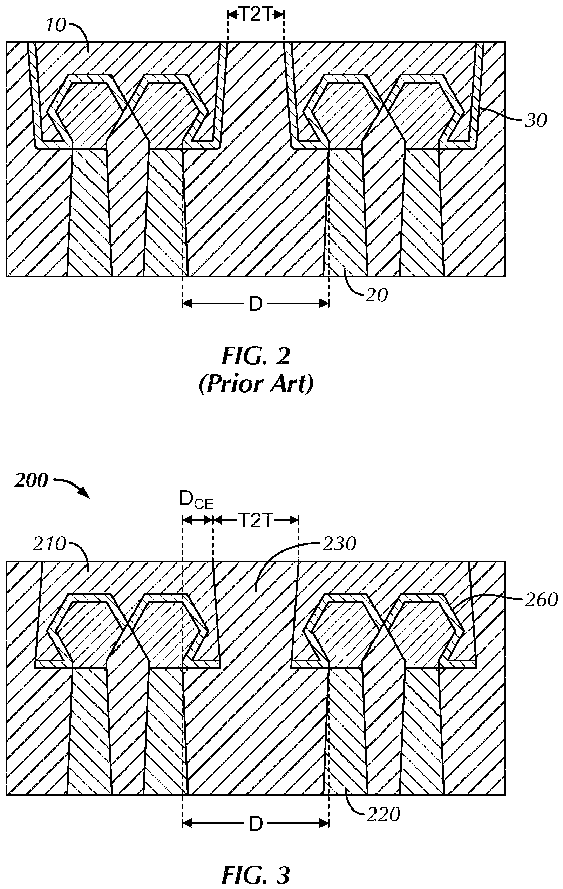

An example of a plurality of fins wherein contacts 10 are interconnecting the fins 20 and wherein the contact cut is performed prior to the contact trench fill is illustrated in FIG. 2. A liner 30 is present at the sidewalls of the contacts. This figure shows two pairs of fins which are each interconnected by a different contact line. As can be seen from this figure the contact cut has a sloped contact sidewall for which the upper corners are closer and the lower corners are further away. This results in an increased contact over fin extension and therefore resulting in a reduced tip to tip (T2T) margin between the contact lines of the different fin pairs. This tip to tip distance defines the margin for the fin to fin distance D. When the tip to tip distance is too small this will conflict with the litho design rules.

In view of an increasing number of transistors per square inch there is a need for methods of forming gate contacts and contact lines with an increased tip to tip margin for the same distance D between the fins, and for transistor cells created using such methods.

### Summary of the invention

It is an object of embodiments of the present invention to provide good methods of forming gate contacts and/or contact lines and good cells obtained using such methods. These cells may for example be used in CMOS devices and in SRAM cells.

The above objective is accomplished by a method and device according to the present invention.

In a first aspect embodiments of the present invention relate to a method of forming gate contacts and/or contact lines on a plurality of fins. The method comprises:
- providing a wafer comprising a semiconductor structure which comprises a plurality of fins,
- patterning at least one continuous trench over the fins,
- filling at least one of the trenches with metal to obtain at least one continuous gate in contact with the fins and/or filling at least one of the trenches with metal to obtain at least one continuous contact line in contact with the fins,
- cutting the metal of the at least one gate and/or cutting the metal of the at least one contact line on locations in between some of the fins.

Compared to prior art methods wherein the contact cut is performed prior to the contact trench fill, in embodiments of the present invention an inversely sloped contact sidewall results in shorter contact over fin extensions. This results in an increased tip to tip margin for a same cell size or in a reduced cell size for the same tip to tip margin.

As no liner metal is present on the side walls, it is an advantage of embodiments of the present invention that no liner metal is present on the contact edges. This opens up the possibility to have more space for a low resistive fill metal compared to the high resistive liner material which is present in prior art contacts.

Performing the gate cut after the RMG metal fill instead of prior to the RMG fill has the advantage that no RMG metals are present on the side walls allowing shorter gate over fin extensions. This results in an increased tip to tip margin.

In embodiments of the present invention a gate cap material is provided over the at least one continuous gate and a contact cap material is provided over the at least one continuous contact line and wherein the gate cap material is different from the contact cap material such that cap materials with different etch selectivity are provided before cutting (140) the metal of the at least one gate and/or the metal of the at least one contact line.

It is an advantage of embodiments of the present invention that both contact and gate metal cuts can be performed in the same step downstream contact module. This is enabled by different etch selectivity of gate and contact cap materials.

It is an advantage of embodiments of the present invention that the gate and contact cut mask overlay requirement is relaxed due to gate and contact cap etch selectivity.

By selecting the appropriate etchants combined or separate gate and contact cut are enabled as required by the design. It is for example possible to cut both gate and contact metals on the cell edge and to cut only gate or only contact metal in the middle of the cell.

It is an advantage of embodiments of the present invention that the gate and contact cut mask overlay requirement is relaxed due to gate and contact cap etch selectivity.

It is an advantage of embodiments of the present invention that the mask count can be reduced by merging some gate and contact cut masks and resolving so-called lithography mask color conflicts.

In embodiments of the present invention the method comprises performing a fin cut after obtaining the at least one metal gate. In embodiments of the present invention the metal gates have already been cut before the fin cut is performed.

It is an advantage of embodiments of the present invention that the fin cut is only performed after obtaining the at least one gate. The gate is obtained by filling a trench over the fin. In embodiments of the present invention the channel stress created upstream in the process flow is "pinned" by the metal gate during the fin cut step.

In embodiments of the present invention the fin cut is only performed after a front end of line process wherein the front end of line process comprises epitaxial growth of source and drain stressors, applying a dummy gate, applying a replacement metal gate, and applying the contact lines.

It is an advantage of embodiments of the present invention that the dummy gate becomes self-aligned to the fin edge. This results in an improved process margin. It is moreover advantageous that the source/drain area is maximized during stressed epilayers growth and that the stress transfer from the source/drain stressed epilayers into the channel is maximized. In case of SiGe fins this is particularly advantageous due to maximized stress from the substrate.

In embodiments of the present invention for the provided wafer comprising the plurality of fins, the plurality of fins are comprising a functional layer of Silicon, or SiGe, or Ge, or InGaAs, or III-V material.

It is an advantage of embodiments of the present invention that the stress from the substrate is maximized in case of SiGe fins.

In embodiments of the present invention the metal used for filling the trenches is Ruthenium or Tungsten.

It is an advantage of embodiments of the present invention that dry etching of the metal is possible. This is particularly advantageous for the metal planarization. In that case there a large topography must be overcome as there is a big difference in height between the S/D. To compensate for this height difference a significant amount of excess metal needs to be deposited. Afterwards planarization is done. For the planarization it is advantageous that the metal is suitable for dry etching.

In a second aspect embodiments of the present invention relate to a cell comprising a plurality of fin transistors on parallel fins wherein contact lines lie in line with each other and wherein contact line cuts between adjacent fins have a slope such that the distance between the contact lines is decreasing with increasing depth and/or wherein gates lie in line with each other and wherein gate cuts between adjacent fins have a slope such that the distance between the gates is decreasing with increasing depth.

It is an advantage of embodiments of the present invention that the tip to tip distance between contact lines of adjacent transistors and/or between gates of adjacent transistors is larger compared to prior art cells having the same cell size. The reason therefore is the inverted slope compared to prior art contact line cuts.

In embodiments of the present invention no liner is present on side walls of the contact lines and/or gates.

It is an advantage of embodiments of the present invention that, without the liner on the side walls, the available space can be dedicated to low resistive metal. Thereby the overall contact resistance can be reduced. In the presence of a liner on the sidewalls the cell size has to be increased to obtain a contact line with the contact resistance (for each cut a space of two times the liner thickness is lost to the low resistive fill metal).

In embodiments of the present invention the fins are comprising Silicon, or SiGe, or Ge, or InGaAs, or III-V material.

In a third aspect embodiments of the present invention relate to a CMOS device comprising a cell in accordance with embodiments of the present invention.

In embodiments of the present invention some of the fins may be nMOS fins while other fins may be pMOS fins.

In a fourth aspect embodiments of the present invention relate to an SRAM cell comprising a cell in accordance with embodiments of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a flow chart of a method in accordance with embodiments of the present invention.
FIG. 2 shows a schematic drawing of a prior art cell comprising a plurality of fins wherein the contact cut is performed prior to the contact trench fill.
FIG. 3 shows a schematic drawing of contact lines and fins of a prior art cell.
FIG. 4 shows a schematic drawing of gates and fins of a cell in accordance with embodiments of the present invention.
FIG. 5 shows a schematic drawing of gates and fins of a cell in accordance with embodiments of the present invention.
FIG. 6 shows a prior art Intel 14 nm SRAM cell comprising continuous and discontinuous fins.
FIG. 7 shows a cell stack with continuous gate and with continuous contact lines covered with gate cap material and contact cap material in accordance with embodiments of the present invention.
FIG. 8 shows a cell stack after etching back the metals of the gate contact and the contact lines in accordance with embodiments of the present invention.
FIG. 9 shows a cell stack after dielectric fill of the cell stack of FIG. 7 and deposition in accordance with embodiments of the present invention.
FIG. 10 shows a cell stack after etching beck the metals of the contact lines in accordance with embodiments of the present invention.
FIG. 11 shows a cell stack after dielectric fill of the cell stack of FIG. 9 and deposition in accordance with embodiments of the present invention.
FIG. 12 shows a cell stack after a fin cut in accordance with embodiments of the present invention.
FIG. 13 shows the end result after depositing a transparent ILD0 oxide in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

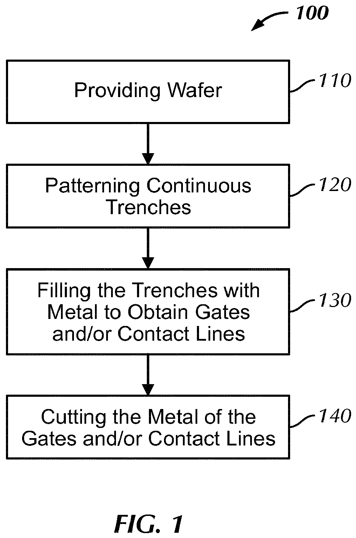

In a first aspect embodiments of the present invention relate to method 100 of forming gate contacts and/or contact lines on a plurality of fins. Method steps of a method in accordance with embodiments of the present invention are schematically illustrated in FIG. 1.

The method comprises providing 110 a wafer comprising a semiconductor structure which comprises a plurality of fins 220.

After providing the fins at least one continuous trench is patterned 120 over the fins.

At least one of the patterned trenches is filled 130 with metal to obtain at least one continuous gate in contact with the fins and/or at least one of the trenches is filled 130 with metal to obtain at least one continuous contact line in contact with the fins.

Methods according to embodiments of the present invention moreover comprise cutting 140 the metal of the at least one gate and/or cutting the metal of the at least one contact line on locations in between some of the fins.

Cutting the contact after the contact trench fill, in accordance with embodiments of the present invention results in an inverted sidewall slope compared to sidewall slopes of contacts wherein the contact cut is performed prior to contact trench fill.

The tip to tip distance will therefore be larger for cells which are obtained using a method in accordance with embodiments of the present invention. Hence, the litho requirements will be relaxed or smaller cell sizes can be obtained using a method in accordance with embodiments of the present invention.

In a second aspect, embodiments of the present invention relate to a cell 200 comprising a plurality of fin transistors on parallel fins 220. The contact lines 240 lie in line with each other and the contact line cuts between adjacent fins 220 have a slope such that the distance between the contact lines is decreasing with increasing depth.

Cells according to embodiments of the present invention may have contact lines 210 which lie in line with each other and contact line cuts 230 between adjacent fins 220 have a slope such that the distance between the gates is decreasing with increasing depth.

An example of such a cell is schematically illustrated in FIG. 3. It shows the fins 220. A first contact line 210 over a first fin pair 220 and a second contact line 210 over a second gate pair 220. A contact line cut 230 is present between the first gate and the second gate. The tip to tip distance (T2T) as well as the distance between two adjacent fins (D) are also indicated in this figure. The figure shows the contact over fin extension (D_{CE}). For a same distance (D) between two fins the tip to tip distance increases and the contact over fin extension decreases when using a method in accordance with embodiments of the present invention.

It is an advantage of embodiments of the present invention no liner metal 260 is present on side walls of the contact lines and/or gates. That opens the possibility to have more space for a low resistive (in comparison with the liner metal) fill metal.

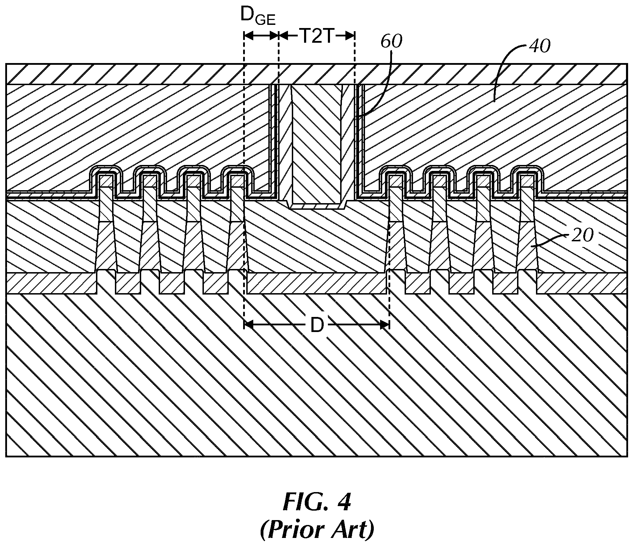

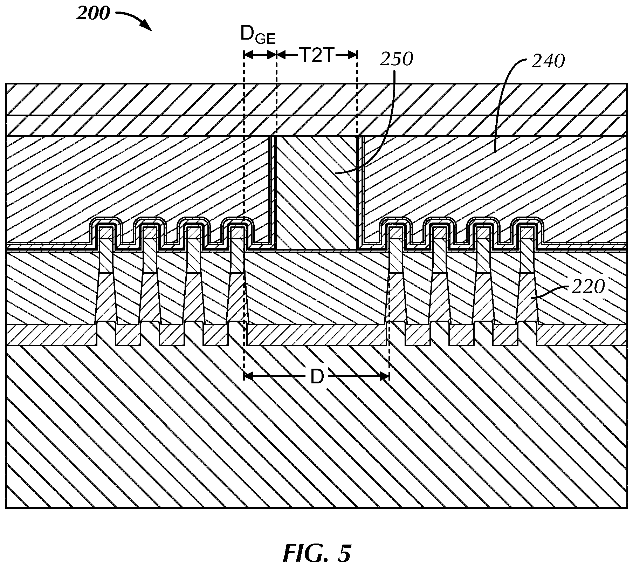

FIG. 4 shows a schematic drawing of a prior art cell. An example of replacement metal gates (RMG) is shown. The distance between adjacent fins (D), the gate over fin extension (D_{GE}) and the tip to tip distance (T2T) are indicated. Such a stack is obtained by doing the gate cut early in the flow (before the trench fill). Next two separate trenches (e.g. for nMOS and for pMOS) are filled with the replacement metal gate (RMG) stack. The gate fill material 40 of the RMG stack is low resistive. The RMG stack comprises the workfunction metal stack 60. This workfunction metal stack 60 on the vertical side wall is there because of the integration process. The RMG metals present on the sidewalls increase the gate over fin extensions and therefore result in a tighter T2T that in a cell in accordance with embodiments of the present invention such as the one illustrated in FIG. 5.

FIG. 5 shows a schematic drawing of a cell 200 in accordance with embodiments of the present invention. The gates 240 covering the fins 220 are shown. In this example the distance between the adjacent fins (D) is the same as in FIG. 4. It is an advantage of embodiments of the present invention that the tip to tip distance (T2T) can be increased. This is achieved by reducing the gate over fin extension (D_{GE}). As can be seen on this figure the workfunction metal stack 60 is not present in FIG. 5. The reason therefore is that the gate cut is performed after the RMG fill. As the RMG metals are absent on the sidewalls shorter gate over fin extensions are possible and therefore it is easier to obtain a certain T2T distance.

Methods according to embodiments of the present invention may comprise performing a fin cut after obtaining the at least one metal gate.

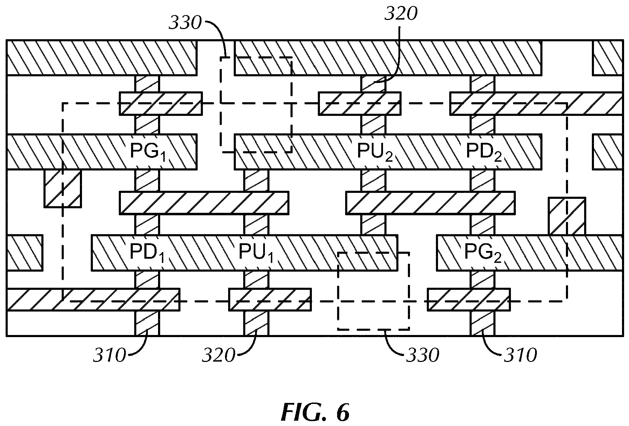

FIG. 6 shows a prior art Intel 14 nm SRAM cell. The figure shows an nMOS fin 310, a discontinuous pMOS fin 320, and pMOS fin cut regions 330.

Traditionally, the fin cut step is performed early in the process flow, at the STI module. This as opposed to some embodiments of the present invention where the fins run uninterrupted throughout the entire front end of line (FEOL) process, including the S/D Epi, RMG, contact modules. Therefore, in these embodiments the stress transfer from the S/D and substrate into the channel is maximized. The fin cut is performed after the contact module, when the channel stress generated upstream in the flow is pinned by the metal gate. In embodiments of the present invention a portion of the fin is exposed after the contact on top of it is removed. It does not necessarily need to be done in the contact cut last scheme. If contact interruption is achieved early in the flow, fin cut last may also be implemented. As the channel stress generated upstream in the flow is pinned by the metal gate, elastic stress relaxation at the fin channel after cutting the fins is avoided because the channel stress is pinned by the metal gate by anchoring the channel and thus limiting the expansion of the channel after cutting the channel.

In embodiments of the present invention the fin cutting is self-aligned to the gate because the gate acts as an additional hard mask. This is possible in embodiments wherein the gate is implemented before cutting the fin. A mask may be added before cutting the fin to define which parts are etched.

In a third aspect embodiments of the present invention relate to a CMOS device comprising cells in accordance with embodiments of the present invention.

In a fourth aspect embodiments of the present invention relate to an SRAM cell in accordance with embodiments of the present invention.

In the following paragraphs an exemplary process flow in accordance with embodiments of the present invention is explained.

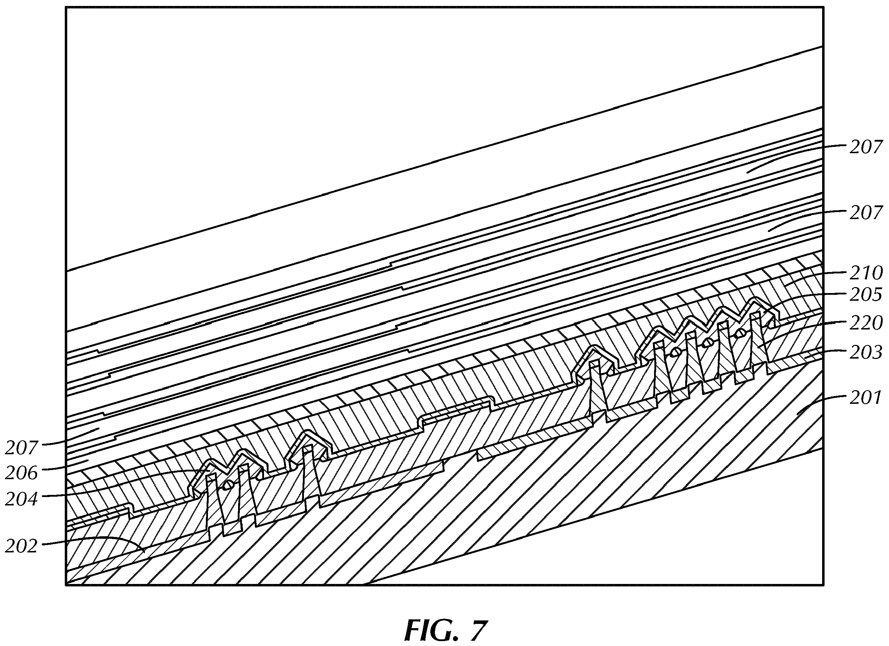

In a first step a wafer is provided. This may for example be a silicon wafer. In this wafer fins are formed. At this stage of the process the fins are continuous uninterrupted fins. A regular pattern of fins may be formed or some fins may be removed. Next STI processing is applied. After the STI processing the traditional well implantation steps are performed. Next gate patterning is performed (e.g. dummy gate module, nMOS extension and HALO module, pMOS extension and HALO module, nMOS spacer patterning, nMOS Si epitaxial growth, pMOS spacer patterning, pMOS Si epitaxial growth, ILD0 module, high-K RMG module CMOS, contact module). By performing a stack according to the schematic drawing in FIG. 7 may be obtained. This figure shows the wafer 201, the pWell 202 and the nWell 203, nMOS Si 204 and pMOS Si 205.

In embodiments of the present invention a gate cap material 207 is provided over the at least one continuous gate and a contact cap material 206 is provided over the at least one continuous contact line 210. The gate cap material 207 is different from the contact cap material 206 such that cap materials with different etch selectivity are provided before cutting the metal of the at least one gate and/or the metal of the at least one contact line.

At this point or some process steps later, the metal of the at least one gate and/or the metal of the at least one contact line may be cut.

In embodiments of the present invention the contact cap material (e.g. SiOC) and the gate cap material (e.g. SiN) are etched with different chemistries. This allows to choose which one to cut the gate, the contact line or both.

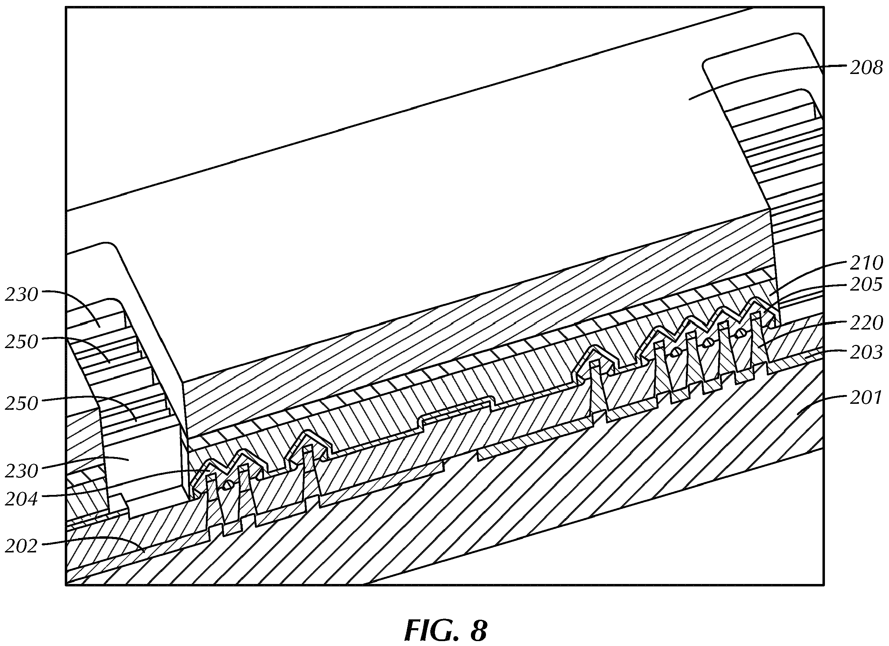

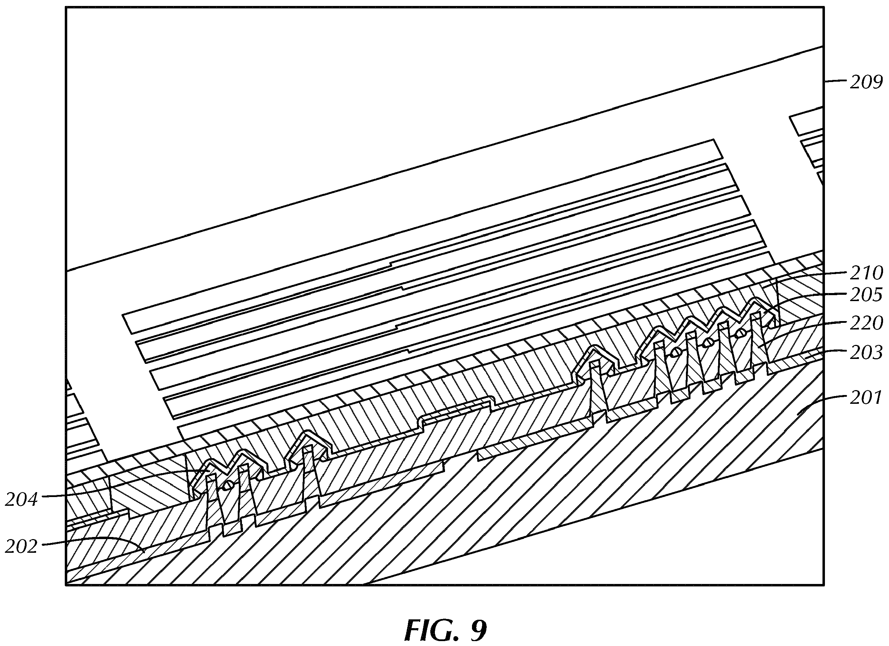

One might for example want to cut both gates and contact metals. This is typically the case at a cell boundary, where the gates and the contact lines are cut to isolate the cell. In that case rectangular shaped masks may be introduced. After applying the spin resist 208, the spin resist is exposed resulting in rectangular shaped holes as illustrated in FIG. 8. At these holes the gate cap material 207 is etched with a first chemistry and the contact cap material 206 is etched away with a second chemistry, after which the underlying metals may be etched away with a third chemistry. These steps electrically interrupt the gates and the contact lines using the same mask but using three different chemistries. The contact line cuts 230 and the gate cuts 250 are indicated in FIG. 8. Next the resist 208 is stripped and the dielectric 209 (e.g. SiO2) is deposited, followed by a polishing (CMP) step. The result thereof is shown in FIG. 9.

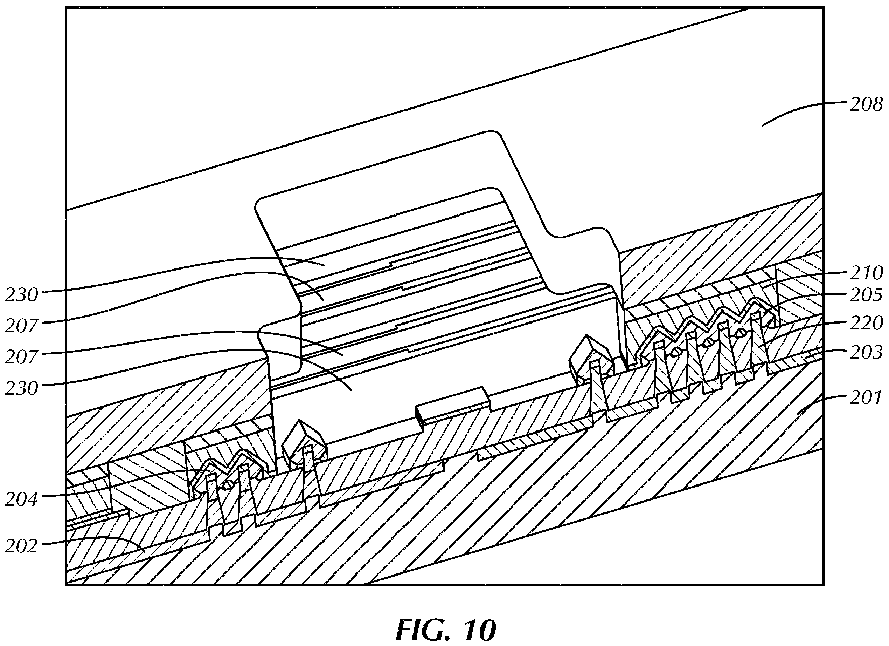

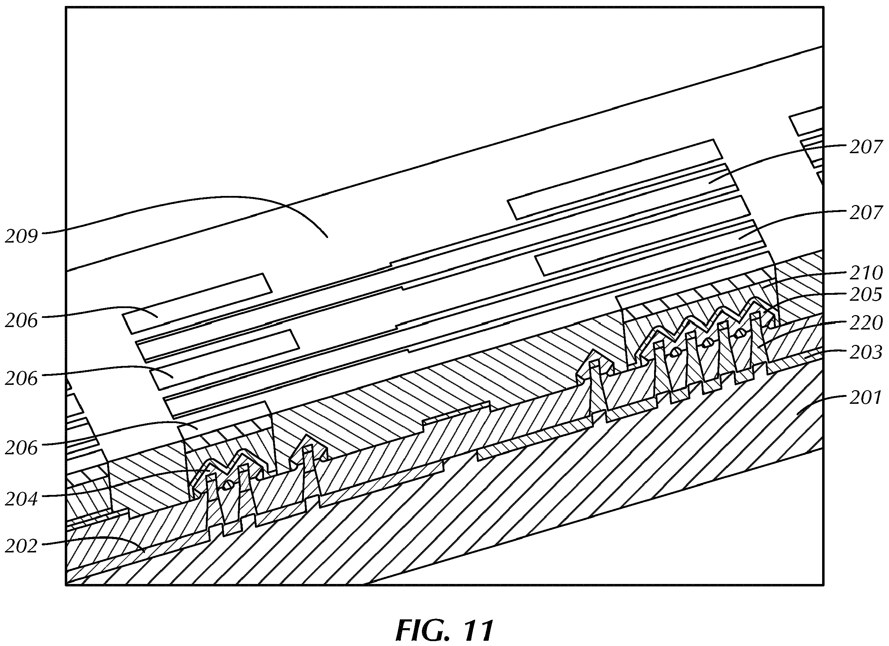

In other cases the metal of the gate contact and the metal of the contact line are not supposed to be cut at the same time. This can for example be the case in the middle of the cell where gates are continuous and then the contacts have to be separated for nMOS and pMOS. In that case after spinning the resist 208 a different mask can be printed. This mask can have different shapes. Only the chemistry that opens the dielectric cap 206 on the contact metal may for example be applied while the gate dielectric cap remains unaffected. Using the third chemistry the metal of the contact lines 210 is etched. The result thereof is shown in FIG. 10 showing the contact line cuts 230, the unaffected gate cap material 207, and the contact line cut 230. Next the resist is removed and the dielectric 209 (e.g. SiO2) is applied and polished (CMP). The result thereof is shown in FIG. 11. Thus, a device can be obtained wherein the contact lines are only present over some of the fins. Some of the fins may for example only be covered by the ILD dielectric.

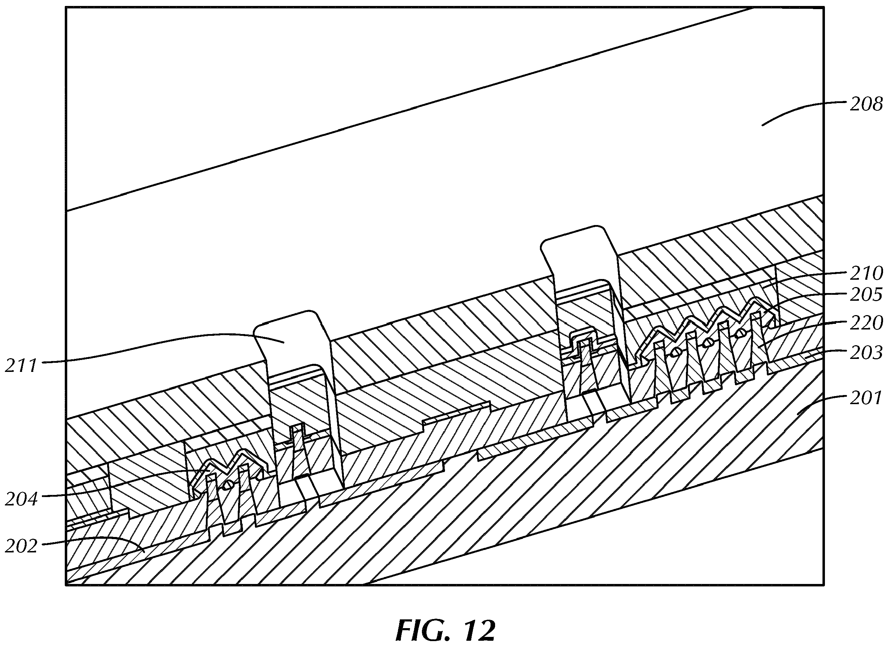

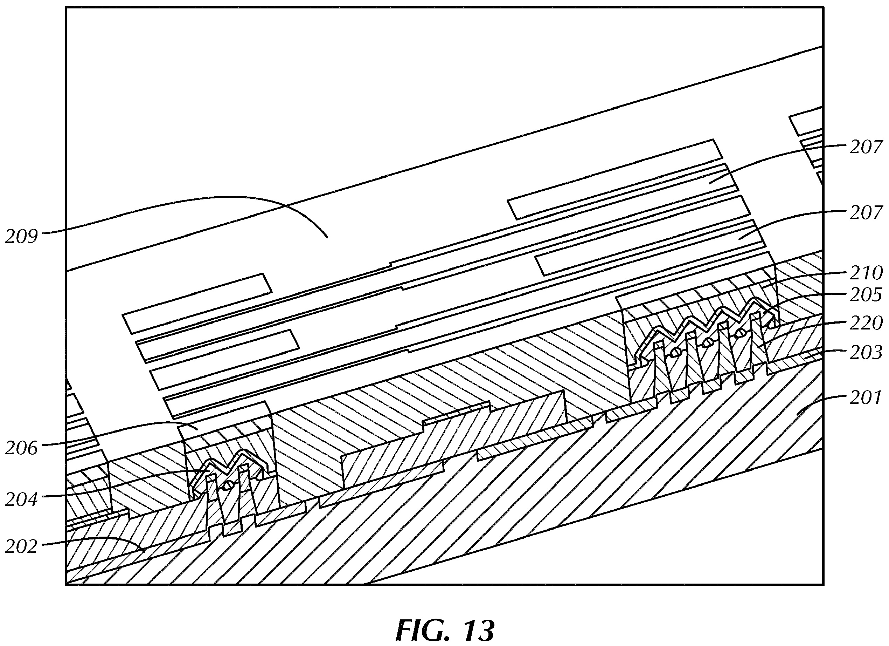

In embodiments of the present invention a fin cut may be done after obtaining the at least one metal gate. The following process steps may be done to obtain such a fin cut. Apply a spin resist 208, expose the resist after having applied a mask, etchback the fin material (e.g. silicon) at the position 211 where the fin should be cut, remove the resist 208, deposit and polish the dielectric (e.g. SiO2). A schematic drawing of a cell stack after etching-back the silicon for cutting the fin is illustrated in FIG. 12. Next the resist is removed and the dielectric 209 (e.g. SiO2) is applied and polished (CMP). The result thereof is shown in FIG. 13.

In the exemplary process flow cited above interruptions to the gate contacts and to the contact lines are postponed to the point where both are metallized and capped each with a different cap material (as required for self-aligned gate contact SAGC further downstream). Interruptions to the gate contacts and to the contact lines can be made differentially by opening of the 2 cap materials and subsequently performing a metal etch of the gate contact or of the contact line. Finally, a fin cut is done after obtaining the at least one metal gate. Therefore, S/D epi grown on non-interrupted fins can be removed selectively opening the ILD0 oxide over the epi (selective to the plugs over gate and contact) and subsequently removing the S/D epi and fin. Interruptions may be filled back with dielectric, followed by CMP step in a single or multiple steps.

## Claims

1. A method (100) of forming gate contacts and/or contact lines on a plurality of fins, the method comprising:
- providing (110) a wafer comprising a semiconductor structure which comprises a plurality of fins,
- patterning (120) at least one continuous trench over the fins,
- filling (130) at least one of the trenches with metal to obtain at least one continuous gate in contact with the fins and/or filling at least one of the trenches with metal to obtain at least one continuous contact line in contact with the fins,
- cutting (140) the metal of the at least one gate and/or cutting the metal of the at least one contact line on locations in between some of the fins.

2. A method (100) according to claim 1 wherein a gate cap material is provided over the at least one continuous gate and a contact cap material is provided over the at least one continuous contact line and wherein the gate cap material is different from the contact cap material such that cap materials with different etch selectivity are provided before cutting (140) the metal of the at least one gate and/or the metal of the at least one contact line.

3. A method (100) according to any of the previous claims the method comprising performing a fin cut after obtaining the at least one gate.

4. A method (100) according to claim 3, wherein the fin cut is only performed after a front end of line process wherein the front end of line process comprises epitaxial growth of source and drain, applying a dummy gate, applying a replacement metal gate, and applying the contact lines.

5. A method (100) according to any of the previous claims wherein for the provided wafer comprising the plurality of fins, the plurality of fins are comprising a functional layer of Silicon, or SiGe, or Ge, or InGaAs, or III-V material.

6. A method (100) according to any of the previous claims wherein the metal used for filling the trenches is Ruthenium or Tungsten.

7. A cell (200) comprising a plurality of fin transistors on parallel fins (220) wherein contact lines (210) lie in line with each other and wherein contact line cuts (230) between adjacent fins (220) have a slope such that the distance between the contact lines is decreasing with increasing depth and/or wherein gates (240) lie in line with each other and wherein gate cuts (250) between adjacent fins (220) have a slope such that the distance between the gates is decreasing with increasing depth.

8. A cell according to claim 7 wherein no liner is present on side walls of the contact lines and/or gates.

9. A cell according to claim any of the claims 7 to 8 wherein the fins are comprising Silicon, or SiGe, or Ge, or InGaAs, or III-V material.

10. A CMOS device comprising a cell in accordance with any of the claims 7 to 9.

11. An SRAM cell comprising a cell in accordance with any of the claims 7 to 10.
